Europäisches Patentamt

European Patent Office

Office européen des brevets

(11) Publication number: **0 506 097 A2**

# EUROPEAN PATENT APPLICATION

(21) Application number: **92105327.8**

(22) Date of filing: **27.03.92**

(51) Int. Cl.5: **H01L 21/306, H01L 21/28**

(30) Priority: **29.03.91 JP 65823/91**

(43) Date of publication of application:
**30.09.92 Bulletin 92/40**

(84) Designated Contracting States:
**DE FR GB**

(71) Applicant: Oki Electric Industry Co., Ltd.
**7-12, Toranomon 1-chome Minato-ku
Tokyo(JP)**

(72) Inventor: **Inokuchi, Kazuyuki, c/o Oki Electric
Industry
Co., Ltd., 7-12, Toranomon 1-chome
Minato-ku, Tokyo(JP)**
Inventor: **Ikeda, Masahisa, c/o Oki Electric
Industry
Co., Ltd., 7-12, Toranomon 1-chome
Minato-ku, Tokyo(JP)**

(74) Representative: **Betten & Resch
Reichenbachstrasse 19
W-8000 München 5(DE)**

(54) **Method of manufacturing a semiconductor device having a layer with a controlled thickness.**

(57) Ultraviolet rays are irradiated on a semiconductor substrate 11 in an oxygen atmosphere. The ultraviolet rays have an energy sufficient for cutting off the bond between oxygen molecules. Ozone produced on the semiconductor substrate forms an oxide film on the outer surface of the semiconductor substrate. By removing the oxide film, the semiconductor substrate is reduced to a desired thickness.

FIG. 5B

EP 0 506 097 A2

FIELD OF THE INVENTION

The present invention relates to a method of manufacturing a semiconductor device, and in particular, to a method of manufacturing a semiconductor device having a layer with a controlled thickness.

[Background of the Invention]

In the manufacture of a semiconductor device such as a metal electrode Shottyky gate field-effect transistor (MES FET), the thickness of the channel layer is adjusted before forming the gate electrode in order to obtain a desired threshold voltage. For example, the literature "Oki Electric Research and Development", vol. 54, No. 2, 1987, page 11, discloses such technology.

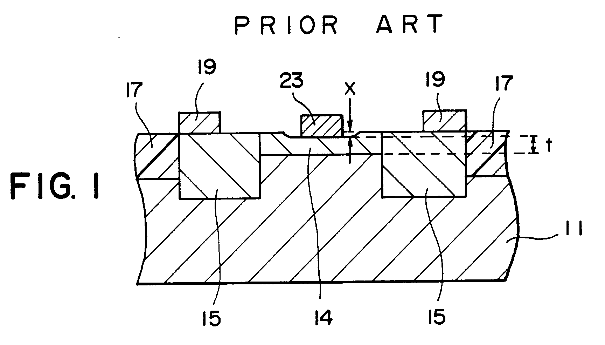

Fig. 1 is a sectional view which shows a conventional MES FET. In this figure, an n-type channel layer 14, n+-type source and drain regions 15 and element isolation regions 17 are formed in a semi-insulating GaAs substrate 11. Ohmic electrodes 19 are formed on the source and drain regions 15, and a gate electrode 23 is formed on the channel layer 14.

The channel layer 14 has a recess of a depth x. This recess is formed by selectively etching the channel layer 14 with the use of wet-etching or dry-etching. Through this etching of the recess, the channel layer 14 can have a thickness t in the gate forming region.

However, if the recess is formed by the wet-etching, the convection of etchant and the dispersion of reactive substance are not uniform. Further, if the dry-etching is used, the irradiation of reactive gas plasma onto a wafer is not uniform. Accordingly, it is difficult to etch uniformly the channel layers 14 of a large number of MES FETs within a single wafer.

[Summary of the Invention]

One object of the present invention is to provide a method of manufacturing a semiconductor device, including a step of precisely and uniformly etching a semiconductor layer.

Another object of the present invention is to provide a method of manufacturing a semiconductor device having a controlled threshold voltage characteristic.

With the use of ultraviolet rays and oxygen, according to the present invention, an oxide film having a uniform thickness is formed on the outer surface of the semiconductor layer. By removing the oxide film, the thickness of the semiconductor layer is decreased accurately. Thus, it is possible to adjust the thickness of a specific semiconductor layer to a desired value.

[Brief Description of the Drawings]

Fig. 1 is a sectional view illustrating a conventional MES FET IC;
Fig. 2A to 2G are sectional views showing a first embodiment of a Shottky FET IC manufacturing process according to the present invention;
Fig. 3A is a view illustrating a wafer which is divided into a plurality of IC chip areas;
Fig. 3B a view illustrating each of the IC chip areas having a test FET;
Fig. 4A is a graph showing a relationship between current Idso flowing between the drain and the source of a Shottky FET, and threshold voltage Vth;
Fig. 4B is a graph showing a relationship between photo oxidation time and thickness of oxide film;
Fig. 5A and 5B are schematic plan and sectional views illustrating a photo oxidizing device used in a second embodiment of the present invention; and
Fig. 6 is a sectional view illustrating a variant form of the embodiment of the present invention.

[Description of the Preferred Embodiment]

Explanation will be made hereinbelow according to embodiments of the present invention. These embodiments are examples in which the present invention is applied to adjust the thickness of an FET channel layer in manufacture of an IC containing a large number of Shottky gate type FETs.

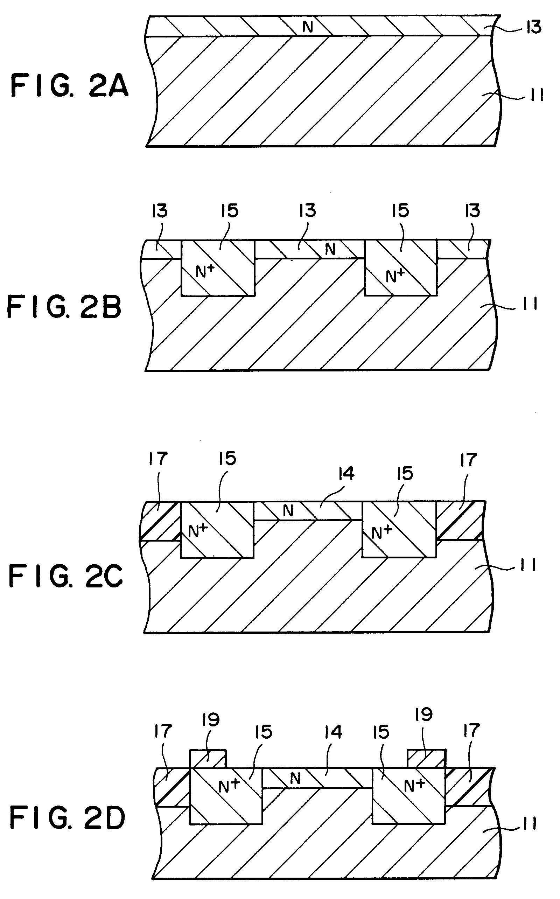

Figs. 2A to 2G show a first embodiment of the present invention.

As shown in Fig. 2A, an n-type GaAs layer 13 is formed on a semi-insulating GaAs substrate 11 by, for example, an epitaxial growth process.

As shown in Fig. 2B, n-type impurity ions are selectively implanted into the GaAs substrate 11 so as to form n+-type source and drain regions 15.

As shown in Fig. 2C, element isolation regions 17 are formed by implanting oxygen ions outside of a region where a FET is to be formed. The remaining n-type GaAs layer 13 acts as a channel layer 14. In an example, the channel layer has a carrier density of $3 \times 10^{17}$ cm$^{-3}$ and further its thickness is 83.3 nm.

As shown in Fig. 2D, ohmic electrodes 19 are formed on the source and drain regions 15. These ohmic drains 19 are formed of AuGe, Ni and Au which are successively deposited. The ohmic electrodes 19 are subjected to heat-treatment so as to obtain ohmic-contact with the source and drain regions 15.

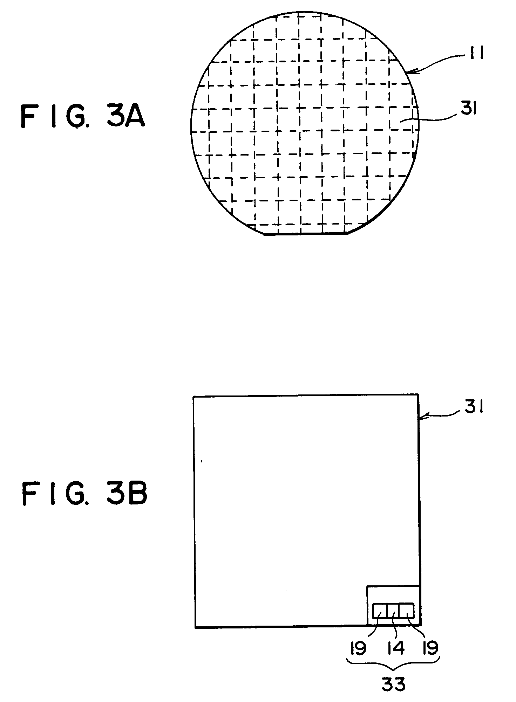

Fig. 3A shows that a semiconductor wafer 11 is divided into a large number of IC chip areas 31 after the above-mentioned steps have been carried out. Further, Fig. 3B shows that a test FET 33 is formed on each of the IC chips 31. The test FET 33 also has the channel layer 14 and the ohmic electrodes 19.

At this stage, a current Idso flowing through the channel layer 14 in this test FET 33 is measured by way of the ohmic electrodes 19. The currents in all test FETs are measured to obtain an averaged value of the current Idso. Further, computation is made to obtain what degree the averaged value is greater than a desired value. The desired value of the current Idso is obtained through a channel layer of a thickness by which provides a desired threshold value.

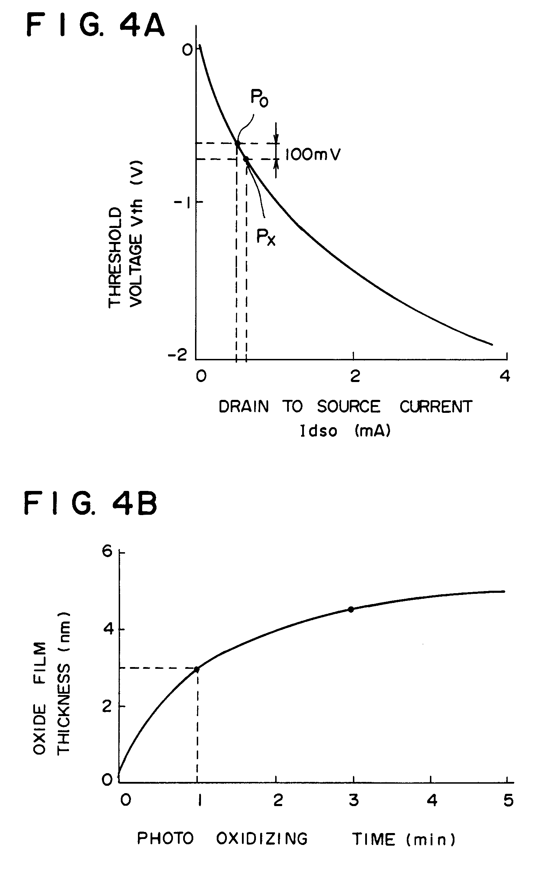

Fig. 4A is a graph showing the relationship between the current Idso and the threshold value Vth which as been previously obtained by an experiment. It is found that the difference between a measured value Px and the desired value Po gives a deviation of 100 mV from the desired threshold value Vth. The etching value x for the channel layer 14 is determined by data (which is not shown) which have been experimentally obtained beforehand. In view of these data, in order to compensate the deviation of 100 mV in this embodiment, it is required that the channel layer 14 is etched by 3 nm.

According to the present invention, the etching of the channel layer 14 can be obtained by photo oxidation and removal of an oxide layer.

At first, the photo oxidation is carried out as follows:

First, the wafer 11 is set in a container having a volume of 2 l and incorporating a low pressure mercury lamp (of 300 W). The distance between the wafer and the mercury lamp is set to, for example, 5 cm. Then, the wafer 11 is heated up to a temperature of 100 deg. C, and oxygen gas is introduced at a rate of 10 l/min into the container while light is irradiated form the low pressure mercury lamp.

The bond of oxygen molecular (O2) is cut off so as to produce ozone. With this ozone and the heating of the substrate, the outer surface of the channel layer 14 is oxidized.

The low pressure mercury lamp used in this embodiment emits ultraviolet rays having wavelengths from 185 to 253 nm. A light source which emits light having an energy which is sufficient to cut off the bond of the oxygen molecular is suitable for the photo oxidation according to the present invention.

Fig. 4B is a graph showing the relationship between the photo oxidation time and the thickness of the channel layer 14. This graph has been experimentally obtained beforehand. For example, an oxide film having a thickness of 0.3 nm can be obtained by the photo oxidation for one minutes.

Fig. 2E shows that the oxide film is formed on the channel layer 14 by the above-mentioned photo oxidation. By the photo oxidation for one minute, the oxide film 35 having an averaged value of 3 nm with a standard deviation of 0.3 nm can be obtained.

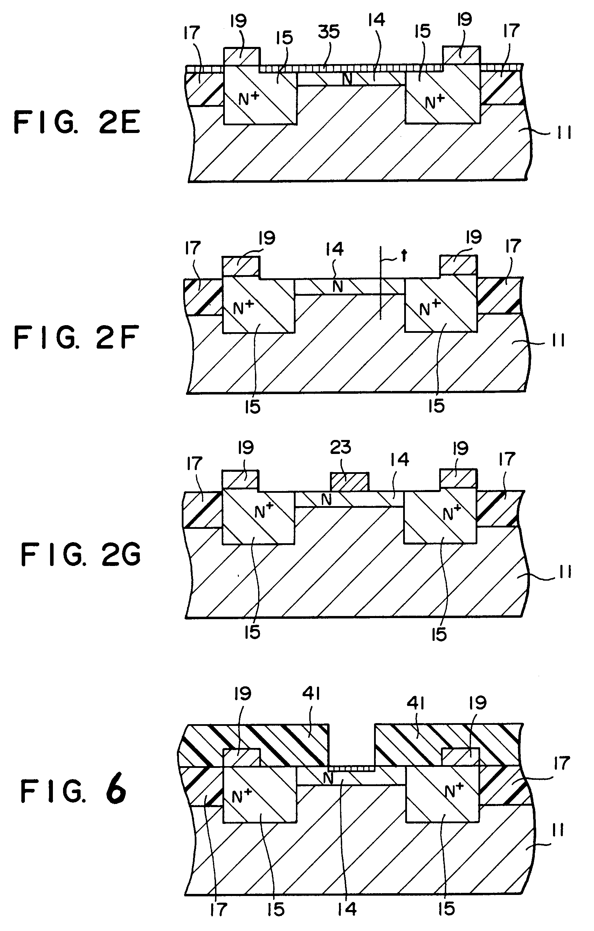

Next, this wafer is washed by ultra-pure water at a flow rate of 3 l/min. With this washing, the oxide film 35 is selectively removed, as shown is Fig. 2F.

After the removal of the oxide film 35, it is found that an oxide film (which is not shown) having a thickness of 0.9 nm is formed on an active layer 13a. It is considered that this oxide film is naturally formed when the channel layer is exposed to the atmosphere after washing.

After twice repetitions os the above-mentioned photo oxidation and the washing by the ultra-pure water, the currents Idso of the test FETs 33 are measured to obtain the averaged value thereof. Idso is decreased by 0.1 mA from the initially measured value.

Then, as shown in Fig. 2G, a gate electrode 23 is formed on the channel layer 14. For example, Ti and Al are successively deposited to form the gate electrode 23. Thereafter, the threshold voltages Vth of the test FETs are measured, and they are all -0.6 V which is a desired value.

As mentioned above, according to the first embodiment, the thickness of the channel layer can be uniformly thinned by changing the time or the cycle numbers of photo oxidation. Accordingly, the threshold voltages of the FETs can be controlled uniformly to a predetermined value within one wafer.

By the way, if the unevenness of Idso among the test FETs before the recess etching is large, it is necessary to change the etching value of the channel layer for each IC chip. Accordingly, explanation will be hereinbelow made according to a second embodiment of the present invention which can be suitably used for such a case.

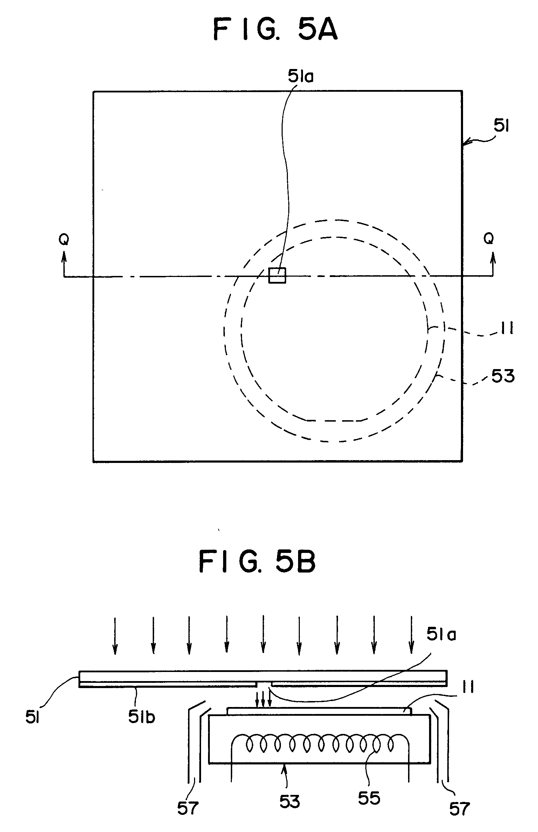

First, with reference to Figs. 5A and 5B, a photo oxidizing device used in the second embodiment of the present invention will be explained. Fig. 5A is a plan view, Fig. 5B is a sectional view taken along the line Q-Q in Fig. 5A.

Referring to these figures, the photo oxidizing device is composed of a quarts mask 51, a stage 53, nozzles 57 and a low pressure mercury lamp (which is not shown).

The quartz mask 51 is covered with a chrome film 51b, excepting a light transmitting window 51a which has an area substantially equal to that of the IC chip area.

The stage 53 can be moved so that any one of the IC chip areas is positioned below the light transmitting window 51a. The stage 53 has a heating means 55 such as an electric heater.

The nozzles 57 are connected to an oxygen bomb (which is not shown) in order to feed oxygen onto the outer surface of the wafer 11. A plurality of such nozzles 57 are arranged concentrically with the substrate 11 so as to supply uniformly oxygen onto the outer surface of the substrate 11.

Contrary to the above-mentioned arrangement, the stage 53 may be stationary while the quartz mask 51 may be moved.

The photo oxidation using the above-mentioned photo oxidizing device is carried out as follows:

At first, as shown in Fig. 5B, the wafer 11 is set on the stage 53. Ultraviolet rays are irradiated onto an IC chip area positioned below the light transmitting window 51a, from the low pressure mercury lamp. High density ozone is produced only above the IC chip area upon which the ultraviolet rays are irradiated, and accordingly, the photo oxidation is effected. The ultraviolet rays are irradiated for a desired time in every IC chip area.

With the photo oxidation under the conditions of the respective IC chip areas, the channel layer of each of the IC chip areas can be oxidized to a predetermined thickness.

Thereafter, the wafer is taken out from the photo oxidizing device, and is washed by pure water. With this washing, the oxide film is removed, and the channel layers of the FETs have thickness by which uniform Idso can be obtained.

As mentioned above, according to the second embodiment, even though the unevenness of Idso among the IC chip areas is large before the recess etching, the threshold voltage can be made to be uniform among FETs within one wafer.

Meanwhile, the time of the photo oxidation can be selected so as to purposely change the thickness of the channel layer for each of the IC chip areas. Accordingly, the threshold voltages of the IC chip areas can be made to different from each other.

The present invention should not be limited to the above-mentioned embodiments alone, but can be modified as follows:

In the above-mentioned embodiments, the channel layer is entirely oxidized, excepting the areas which are covered with the ohmic electrodes 19 (refer to Fig. 2E). However, only an area where the gate electrode is formed can be etched. In this case, as shown in Fig. 6, a photoresists 41 are formed, excepting the area where the gate electrode is formed. Thereafter, the photo oxidation is carried out.

The present invention can be applied to not only a GaAs shottky gate FET but also other FETs such as a junction type FET, an insulating gate FET. Further, the present invention can be applied for adjusting the thickness of drain and source regions in an FET, the thickness of another semiconductor layer or the thickness of a resistance layer. It can be also applied to semiconductor devices having a layer whose thickness is to be adjusted.

The substrate according to the present invention can be applied to not only GaAs but also compound semiconductors such as InP, Gap, AlGaAs, and InGaAs, or monoelement semiconductors such as Si and Ge. The semiconductor layers of them can be photo-oxidized, and the thus oxidized portions can be selectively removed by pure water or chemicals. It can be expected that the present invention is applied to materials such as SiC, boron nitride, tantalum nitride or the like.

In view of the foregoing, according to the present invention, the semiconductor layer can be oxidized with the use of ultraviolet rays, oxygen and heat. Accordingly, the thickness of the oxide film thereon can be made to be uniform within one wafer. Further, the thicknesses of the oxide films in the IC chip areas can be made to be different from each other.

Accordingly, by utilizing the present invention for adjustment to the thickness of the channel layer in an FET, the threshold voltage of the FETs can be made to be uniform within one wafer, or can be changed to an optional value for each of a plurality of FETs included in an IC chip area.

## Claims

1. Method of manufacturing a semiconductor device, comprising the steps of:
   irradiating ultraviolet lays to a semiconductor substrate having a surface and a thickness in an oxygen gas atmosphere so as to produce ozone on said semiconductor substrate in order to form an oxide film on the surface of said semiconductor substrate, and
   removing said oxide film so as to decrease said semiconductor substrate to a desired thickness.

2. A method of manufacturing a semiconductor device as set forth in claim 1, wherein said ultraviolet rays has an energy which is sufficient to cut off the bond between oxygen molecules.

3. A method of manufacturing a semiconductor device as set forth in claim 1, wherein said ultraviolet rays contains light having a wave length from 185 nm and/or light having a wave length of 254 nm.

4. A method of manufacturing a semiconductor device as set forth in claim 1, wherein said semiconductor substrate is divided into a plurality of IC chip areas, and said ultraviolet rays are irradiated to a selected one of said IC chip areas.

5. A method of manufacturing a semiconductor device as set forth in claim 1, wherein said semiconductor substrate is a GaAs substrate, and wherein said oxide film is removed by washing said semiconductor substrate with the use of pure water.

6. A method of manufacturing a semiconductor device comprising the steps of:

forming a semiconductor layer on a semiconductor substrate;

irradiating ultraviolet lays to said semiconductor layer having a surface and a thickness in an oxygen gas atmosphere so as to produce ozone on said semiconductor layer in order to form and oxide film on the surface of said semiconductor layer, and

removing said oxide film so as to decrease said semiconductor layer to a desired thickness.

7. A method of manufacturing a semiconductor device as set forth in claim 6, wherein said semiconductor layer is a GaAs layer, and wherein said oxide film is removed by washing the said semiconductor layer with the use of pure water.

8. A method of manufacturing a field-effect transistor comprising the steps of:

forming a channel layer having a surface and a thickness, a source region and a drain region in said semiconductor substrate;

forming electrodes respectively on said source and drain regions,

irradiating ultraviolet rays onto said semiconductor substrate in an oxygen gas atmosphere so as to produce ozone on said semiconductor substrate in order to form an oxide film at least on the surface of said channel layer,

removing said oxide film so as to reduce said channel layer to a desired thickness, and

forming a gate electrode on said channel layer.

9. A method of manufacturing a field-effect transistor comprising the steps of:

forming a first conductive type semiconductor layer on a semiconductor substrate,

selectively doping said semiconductor layer with impurity so as to form a source region and a drain region while using said semiconductor layer between said source region and said drain region as a channel layer having a surface and a thickness,

forming electrodes respectively on said source region and said drain region,

irradiating ultraviolet rays onto said semiconductor substrate in an oxygen atmosphere so as to produce ozone on said semiconductor substrate in order to form an oxide film on the surface of said channel layer,

removing said oxide film so as to decrease said channel layer to a desired thickness, and

forming a gate electrode on said channel layer.

PRIOR ART

FIG. 1

FIG. 2A

FIG. 2B

FIG. 2C

FIG. 2D

FIG. 2E

FIG. 2F

FIG. 2G

FIG. 6

FIG. 3A

FIG. 3B

# F I G. 4A

# F I G. 4B

# F I G. 5A

# FI G. 5B